Europäisches Patentamt

European Patent Office

Office européen des brevets

(11) Veröffentlichungsnummer: **0 414 123 A2**

## (12) EUROPÄISCHE PATENTANMELDUNG

(21) Anmeldenummer: **90115663.8**

(22) Anmeldetag: **16.08.90**

(51) Int. Cl.⁵: **H03M 3/02**

(30) Priorität: **23.08.89 DE 3927760**

(43) Veröffentlichungstag der Anmeldung:
**27.02.91 Patentblatt 91/09**

(84) Benannte Vertragsstaaten:
**DE FR GB IT SE**

(71) Anmelder: **Blaupunkt-Werke GmbH**
**Robert-Bosch-Strasse 200**
**D-3200 Hildesheim(DE)**

(72) Erfinder: **Hegeler, Wilhelm**
**Grosse Venedig 23**
**D-3200 Hildesheim(DE)**

(74) Vertreter: **Eilers, Norbert, Dipl.-Phys.**
**Blaupunkt-Werke GmbH**
**Robert-Bosch-Strasse 200**
**D-3200 Hildesheim(DE)**

(54) **Analog/Digital-Wandler.**

(57) Bei einem Analog/Digital-Wandler mit einem Komparator, dem das zu wandelnde Analogsignal und ein Vergleichssignal zuführbar ist, ist ein Zähler mit einer Taktfrequenz vorgesehen, die größer als die höchste im Analogsignal enthaltene Frequenz ist. Ausgangssignale des Komparators sind dem Zähler zur Steuerung der Zählrichtung zuführbar. Ausgangssignale des Zählers werden zur Bildung des Vergleichssignals verschieden bewertet integriert.

Fig. 1

## ANALOG/DIGITAL-WANDLER

Die Erfindung geht aus von einem Analog/Digital-Wandler nach der Gattung des Hauptanspruchs.

Bei Analog/Digital-Wandlern nach dem sogenannten Delta-Verfahren - im folgenden Delta-Wandler genannt - wird das zu wandelnde Analogsignal mit einem Vergleichssignal verglichen. Das binäre Signal, welches das Vergleichsergebnis darstellt, wird jeweils für die Periodendauer eines Taktsignals gespeichert und bildet nach einer Integration das Vergleichssignal. Statt eines Integrators wird häufig ein Tiefpaß verwendet. Das Ausgangssignal eines derartigen Delta-Wandlers stellt einen 1-bit-Datenstrom dar, der im wesentlichen die zeitliche Änderung (Steigung bzw. erste Ableitung nach der Zeit) des Eingangssignals darstellt.

Bei Delta-Wandlern wird das Analogsignal dem nichtinvertierenden Eingang eines Komparators zugeführt, während der invertierende Eingang mit dem durch Integration des Ausgangssignals entstandenen Vergleichssignal beaufschlagt ist. Eine Variante der Delta-Wandler stellen sogenannte Sigma-Delta-Wandler dar, bei welchen das Analogsignal über einen Widerstand dem invertierenden Eingang des Komparators zugeführt wird.

Nachteilig ist bei den Delta-Wandlern die Begrenzung der Dynamik, das heißt das Verhältnis von Maximalpegel zu Minimalpegel.

Aufgabe der vorliegenden Erfindung ist es, einen einfach zu realisierenden Analog/Digital-Wandler mit einer größeren Dynamik anzugeben als bei den bekannten Delta-Wandlern.

Der erfindungsgemäße Analog/Digital-Wandler mit den kennzeichnenden Merkmalen des Hauptanspruchs hat gegenüber den bekannten Delta-Wandlern eine etwa um den Faktor $2^{m-1}$ größere Dynamik und läßt sich mit einfachen Schaltungen verwirklichen.

Durch die in den Unteransprüchen aufgeführten Maßnahmen sind vorteilhafte Weiterbildungen und Verbesserungen der im Hauptanspruch angegebenen Erfindung möglich.

Ausführungsbeispiele der Erfindung sind in der Zeichnung anhand mehrerer Figuren dargestellt und in der nachfolgenden Beschreibung näher erläutert. Es zeigt:

Fig. 1 einen bekannten Delta-Wandler,
Fig. 2 ein erstes Ausführungsbeispiel und
Fig. 3 ein zweites Ausführungsbeispiel.

Gleiche Teile sind in den Figuren mit gleichen Bezugszeichen versehen.

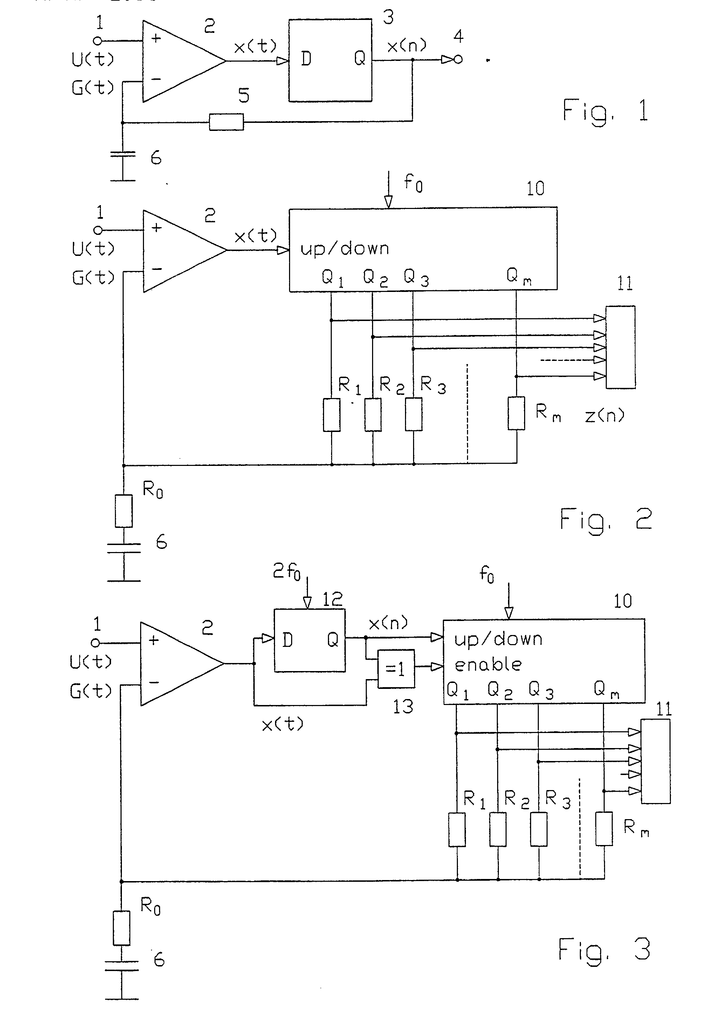

Der in Fig. 1 dargestellte bekannte Delta-Wandler weist einen Eingang 1 auf, dem das Analogsignal U(t) zugeführt wird. Der Eingang 1 ist mit dem nichtinvertierenden Eingang eines Komparators 2 verbunden, dessen invertierender Eingang mit einem Vergleichssignal G(t) beaufschlagt ist. Das binäre Ausgangssignal x(t) des Komparators 2 nimmt einen ersten Pegel ein, wenn U(t) größer als G(t) ist und einen zweiten Pegel, wenn G(t) größer als U(t) ist.

Der Ausgang des Komparators 2 ist mit dem D-Eingang eines Flip-Flops 3 verbunden, das mit einem Taktsignal der Frequenz $f_0$ getaktet wird. Damit steht am Q-Ausgang des Flip-Flops 3 und damit auch am Ausgang 4 des Delta-Wandlers ein Signal x(n) an, welches durch zeitliche Quantisierung des Signals x(t) entstanden ist. Durch eine Integration mit Hilfe des R/C-Gliedes 5, 6 wird das Vergleichssignal G(t) gewonnen.

Die Dynamik des bekannten Delta-Wandlers läßt sich mit folgender Rechnung grob abschätzen: Das maximale Signal der Frequenz f wird in G(t) erzeugt, indem x(n) periodisch abwechselnd $(f_0/2f)$ Nullen und $(f_0/2f)$ Einsen enthält. Der maximale Signalpegel ohne erheblichen Klirrfaktor kann etwa um 3dB niedriger angenommen werden. Das minimale Signal wird zu Zwecken der Abschätzung der Dynamik derart angenommen, daß in jeder Halbwelle eine Eins mehr bzw. weniger als Nullen auftreten, wobei wiederum 3dB über dem sich daraus ergebenden Wert als Untergrenze des Dynamikbereichs angenommen werden.

Ohne Berücksichtigung dieser Abstände zu den rechnerischen Grenzen sind in jeder Halbwelle maximal $(f_0/2f)$ und minimal eine Einzelinformation an der Signalbildung beteiligt. Die restlichen sind infolge des Toggelns unbeteiligt. Die erreichte Dynamik ist somit $(f_0/2f)$ bzw. unter Berücksichtigung der Abstände von insgesamt 6dB $(f_0/4f)$. Bei einer Taktfrequenz von $f_0$ = 8 MHz und einer Signalfrequenz von f = 20 kHz ergibt sich somit $(f_0/4f)$ = 100 bzw. 40dB.

Bei dem Ausführungsbeispiel gemäß Fig. 2 ist der Ausgang des Komparators mit einem Eingang up/down zur Steuerung der Zählrichtung eines Zählers 10 verbunden. Der Zähler 10 wird mit einem Taktsignal der Frequenz $f_0$ getaktet. Der Zähler 10 ist mit Überlaufsperren versehen, so daß er bei Erreichen des maximalen bzw. minimalen Zählerstandes bei einem Wert von x(t), der einen Überlauf zur Folge hätte, stehenbleibt. Die Kapazität des Zählers 10 kann den jeweiligen Erfordernissen angepaßt werden. Eine entsprechende Anzahl von Ausgängen $Q_1$ bis $Q_m$ ist vorgesehen.

Der mehrstellige Zählerausgang bildet gleichzeitig den Ausgang 11 des Analog/Digital-Wandlers mit dem Ausgangssignal z(n). Jeder der Ausgänge $Q_1$ bis $Q_m$ ist über einen Widerstand $R_1$ bis $R_m$ mit dem invertierenden Eingang des Komparators 2 verbunden, wobei die Werte der Widerstände $R_1$ bis $R_m$ binär gestuft sind. Anstelle der Widerstände $R_1$ bis $R_m$ können auch Stromquellen mit binär gestuften Strömen vorgesehen sein.

Bei dem erfindungsgemäßen Analog/Digital-Wandler erfolgt außer einer Integration im Gegenkopplungszweig eine Integration durch den Zähler 10. Der Zählbereich des m-stufigen Zählers 10 erstreckt sich von 0 bis $2^m$-1.

Der Widerstand $R_0$, der klein gegenüber den Widerständen $R_1$ bis $R_m$ ist, dient zur Bedämpfung von Regelschwingungen, die mit $R_0$ = 0 bis zum maximalen Pegel anwachsen würden. Durch den Widerstand $R_0$ wird bezüglich G(t) ein kleiner Anteil der nur einmal integrierten Größe z(n) zu der zweimal integrierten Größe addiert. Durch geeignete Wahl von $R_0$ können die Regelschwingungen (hochfrequentes Toggeln ähnlich wie beim Delta-Wandler) auf ±1 bezüglich z(n) reduziert werden.

Unter der Voraussetzung, daß das Toggeln auf kleine Werte beschränkt bleibt und daß $f_0$ genügend hoch ist und daß z(n) seinen Wertebereich in einem kleinen Teil der Periode des Analogsignals durchlaufen kann (z. B. $2^m$ = $f_0$/4f), wird die Abhängigkeit der erreichbaren Dynamik quadratisch vom Frequenzverhältnis nach der folgenden Gleichung

Delta²-Dynamik = $2^{m-1}$ * Delta-Dynamik = $2^{m-1}$ * ($f_0$/4f) = ($f_0$/f)²/32.

Für das bereits im Zusammenhang mit dem bekannten Delta-Wandler genannte Beispiel von $f_0$ = 8 MHz und f = 20 kHz ergibt sich somit eine Dynamik von 5000 bzw. 74dB.

Abgesehen von technologisch gegebenen Grenzen, kann bei einer Verdoppelung der Oszillatorfrequenz $f_0$ oder Halbierung der Nutzfrequenz f der Zähler ohne Nachteile um eine Stufe ergänzt werden. Beide Maßnahmen erhöhen die Dynamik jeweils um 6dB, das heißt insgesamt um 12dB.

Der 1-bit-Datenstrom x(n) enthält wie bei dem Delta-Wandler die erste Ableitung nach der Zeit von z(n) und im wesentlichen, d. h. in seinen niederfrequenten Komponenten, die zweite Ableitung nach der Zeit von U(t) bzw. G(t), was die in der obengenannten Gleichung verwendete Bezeichnung Delta²-Wandler rechtfertigt. Die Weiterverarbeitung der Zahlenfolge z(n) geschieht zweckmäßigerweise zunächst in einem parallel arbeitenden Addierer, der Bestandteil eines digitalen Filters sein kann, welches eine dem Eingangssignal im gewünschten Frequenzbereich entsprechende Zahlenfolge erzeugt.

Bei dem in Fig. 2 dargestellten Ausführungsbeispiel ist die erreichbare Dynamik jedoch nur um den Faktor $2^{m-2}$ größer als die des Delta-Wandlers, da ohne Begrenzung des Zahlenbereichs nur die Hälfte aller Werte von z(n) erreichbar ist. Dabei ist die Summe zweier benachbarter Werte z(n) immer ungerade, entsprechend:

z(n) + z(n-1) = 2 * z(n-1) ±1.

Ohne Begrenzung von z toggelt die geringstwertige Binärstelle von z permanent und liefert daher keinen Beitrag zur Information. Sie kann somit bei der Weiterverarbeitung von z(n) weggelassen werden.

Eine Verbesserung des Ausführungsbeispiels nach Fig. 2 ist jedoch dadurch möglich, daß die Inkremente von z(n) außer den Zuständen +1 und -1 auch den Zustand 0 annehmen können. Dazu ist bei dem Ausführungsbeispiel nach Fig. 3 zwischen den Ausgang des Komparators 2 und den Eingang up/down des Zählers 10 ein Flip-Flop 12 geschaltet, das mit doppelter Taktfrequenz getaktet wird. Sowohl das Ausgangssignal als auch das Eingangssignal des Flip-Flops 12 werden Eingängen einer Exklusiv-Oder-Schaltung 13 zugeführt, deren Ausgang mit einem Enable-Eingang des Zählers 10 verbunden ist. Dadurch ist z(n) = z(n-1) möglich.

## Ansprüche

1. Analog/Digital-Wandler mit einem Komparator, dem das zu wandelnde Analogsignal und ein Vergleichssignal zuführbar ist, dadurch gekennzeichnet, daß ein Zähler (10) mit einer Taktfrequenz vorgesehen ist, die größer als die höchste im Analogsignal enthaltene Frequenz ist, daß Ausgangssignale des Komparators (2) dem Zähler (10) zur Steuerung der Zählrichtung zuführbar sind und daß Ausgangssignale des Zählers zur Bildung des Vergleichssignals verschieden bewertet integriert werden.

2. Analog/Digital-Wandler nach Anspruch 1, dadurch gekennzeichnet, daß dem bewerteten und integrierten Ausgangssignal des Zählers (10) ein Proportionalanteil des bewerteten Ausgangssignals des Zählers (10) überlagert wird.

3. Analog/Digital-Wandler nach Anspruch 1, dadurch gekennzeichnet, daß der Ausgang des Komparators (2) mit einem Steuereingang (up/down) zur Steuerung der Zählrichtung des Zählers (10) verbunden ist, daß die Ausgänge ($Q_1$ bis $Q_m$) des Zählers (10) je über einen Widerstand ($R_1$ bis $R_m$) mit dem Eingang des Komparators (2) für das Vergleichssignal verbunden sind und daß der Eingang des Komparators (2) für das Vergleichssignal ferner über die Reihenschaltung aus einem weiteren Widerstand ($R_0$) und aus einem Kondensator (6) mit festem Potential verbunden ist.

4. Analog/Digital-Wandler nach Anspruch 3, dadurch gekennzeichnet, daß der Ausgang des Komparators (2) über ein Flip-Flop (12) mit dem Steuereingang (up/down) des Zählers verbunden ist und daß der Ausgang des Komparators (2) und der Steuereingang des Zählers (10) über eine Exklusiv-Oder-Schaltung (13) mit einem weiteren Steuereingang (enable) des Zählers (10) verbunden sind.

5. Analog/Digital-Wandler nach Anspruch 4, dadurch gekennzeichnet, daß das Flip-Flop (12) mit doppelter Taktfrequenz getaktet wird.

6. Analog/Digital-Wandler nach einem der Ansprüche 1 bis 5, dadurch gekennzeichnet, daß das zu wandelnde Analogsignal über einen Widerstand demselben Anschluß des Komparators zugeführt wird wie das Vergleichssignal, und daß der andere Eingang des Komparators auf festes Potential gelegt wird.

R.-Nr. 2065

Fig. 1

Fig. 2

Fig. 3